# EUROPEAN PATENT SPECIFICATION

(11) **EP 3 327 491 B1**
(45) Date of publication and mention of the grant of the patent: **30.12.2020**
(21) Application number: 17202026.5
(22) Date of filing: 16.11.2017
(51) Int. Cl.: G02F 1/13, G02F 1/1333, B05B 13/02, B05B 12/18, B05B 12/34, B05B 12/32, B05D 3/04, B05D 1/02, B05D 1/40, H01L 21/67, H01L 51/00, G03F 7/30, H01L 51/56, B05B 1/14, B32B 17/10

(54) **ROLL TO ROLL FABRICATION APPARATUS**
HERSTELLUNGSVORRICHTUNG VON WALZE ZU WALZE
APPAREIL DE FABRICATION DE ROULEAU À ROULEAU

(30) Priority: 28.11.2016 KR 20160159701
(43) Date of publication of application: 30.05.2018
(73) Proprietor: LG Display Co., Ltd., Seoul, 07336 (KR)
(72) Inventor: LEE, Kyu-Hwang, 10845 Paju-si, Gyeonggi-do (KR); KIM, ChulHo, 10845 Paju-si, Gyeonggi-do (KR); KOOK, YunHo, 10845 Paju-si, Gyeonggi-do (KR)
(74) Representative: Viering, Jentschura & Partner mbB Patent- und Rechtsanwälte

(56) References cited:
- EP-A2- 2 428 992
- JP-A- 2003 243 801
- US-A- 4 428 659
- US-A- 5 374 331

## Description

### BACKGROUND

### Technical Field

This specification relates to a roll to roll fabrication apparatus, and more particularly, to a roll to roll fabrication apparatus capable of rapidly performing processes and capable of uniformly performing a developing process.

### Description of the Related Art

Recently, a flexible display device using a ductile substrate such as a plastic substrate is being developed for enhanced portability and convenience. Such a flexible display device is fabricated in a following manner. Firstly, a substrate formed of a plastic material such as polyimide is attached onto a mother substrate formed of glass. Then, a plurality of display panels are formed on the mother substrate through various processes including a TFT process, then the mother substrate is cut in unit of the display panels, and the plastic substrate is separated from the mother substrate.

However, the conventional method to fabricate such a flexible display device has the following problems.

Recently, ongoing researches are actively conducted to reduce fabrication costs of an expensive display device by fabricating the display device through a consecutive inline process. However, in case of attaching a plastic substrate onto a glass mother substrate, the expensive glass substrate of a large area is required. This may cause fabrication costs to be increased, and equipment and processes to be additionally required since the plastic substrate and the glass substrate should be attached to each other and then separated from each other. As a result, entire fabrication costs are increased.

Further, processes are performed in each unit of the mother substrate, even if a plurality of display panels are formed on the large mother substrate (glass substrate). As a result, a consecutive inline process cannot be performed. Prior art with regard to the subject-matter of the claimed invention can be found in the documents JP 2003 243801 A, US 4 428 659, US 5 374 331, EP 2 428 992.

### BRIEF SUMMARY

Therefore, aspects of the detailed description provide a roll to roll fabrication apparatus capable of performing an inline process rapidly and consecutively, by forming display panels on a film which is transferred between rolls.

Other aspects of the detailed description provide a roll to roll fabrication apparatus capable of preventing a chemical treatment liquid for a corresponding process region from being introduced into another process region by using liquid blocking rolls, and capable of maintaining a uniform thickness of the applied chemical treatment liquid.

To achieve these and other advantages and in accordance with the purposes of this specification, as embodied and broadly described herein, there is provided a roll to roll fabrication apparatus, according to claim 1. Further embodiments are disclosed in the appended dependent claims 2-7.

### BRIEF DESCRIPTION OF THE SEVERAL VIEWS OF THE DRAWINGS

The accompanying drawings, which are included to provide a further understanding of the disclosure and are incorporated in and constitute a part of this specification, illustrate exemplary embodiments and together with the description serve to explain the principles of the disclosure.

### BRIEF DESCRIPTION OF THE SEVERAL VIEWS OF THE DRAWINGS

FIG. 1 is a flowchart showing a method for fabricating an organic electroluminescent device;
FIG. 2 is a flowchart showing a method for forming an electrode of a display device;
FIG. 3 is a view showing a roll to roll fabrication apparatus according to the present disclosure;
FIGS. 4A and 4B are views showing a film of the roll to roll fabrication apparatus according to the present disclosure;
FIGS. 5A and 5B are views showing a structure of a developing unit of the roll to roll fabrication apparatus according to the present disclosure;
FIG. 6 is a view showing a structure of an inject plate of the roll to roll fabrication apparatus according to the present disclosure;
FIG. 7 is a view showing an inject region on a film, the region onto which a developing solution is injected from an inject plate;
FIG. 8 is a view showing an injected state of a developing solution onto a film, in a roll to roll fabrication apparatus having no liquid blocking roll; and
FIG. 9 is a view showing that air is being injected onto a film from an air curtain, in a roll to roll fabrication apparatus according to the present disclosure.

### DETAILED DESCRIPTION

Hereinafter, the present disclosure will be explained in more detail with reference to the attached drawings.

In the present disclosure, a flexible display device is fabricated not in a manner that a ductile substrate such as a plastic substrate is attached onto a mother substrate formed of glass, but in a roll to roll manner. That is, the flexible display device is fabricated by implementing a plastic ductile substrate in the form of a film, by winding the film on two rolls, and then by transferring the film between the rolls.

Since processes to attach a ductile substrate onto an expensive glass mother substrate and to separate the ductile substrate from the glass mother substrate are not required in the present disclosure, fabrication costs may be reduced and fabrication processes may be simplified. Further, since the fabrication processes can be performed while a film is being consecutively transferred, an inline process can be rapidly performed in a narrow space.

Hereinafter, the roll to roll fabrication apparatus(es) according to the present disclosure will be explained by taking a specific display device as an example. However, the roll to roll fabrication apparatus according to the present disclosure may be applicable to all types of display device as well as such a specific display device. Further, the roll to roll fabrication apparatus according to the present disclosure may be applicable to all devices which include a metallic pattern, such as a lighting apparatus including an organic light emitting device.

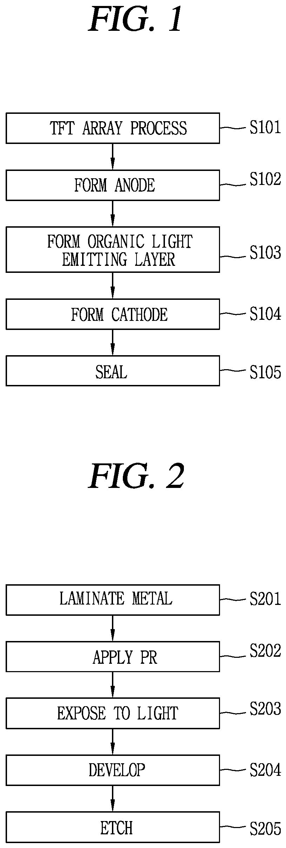

FIG. 1 is a flowchart showing a method for fabricating an organic electroluminescent device.

As shown in FIG. 1, a plurality of gate lines and data lines which define pixel regions are formed on a film where display panels are formed in a single row or a plurality of rows, in a lengthwise direction. Then, a thin film transistor (TFT), a driving device connected to the gate line and the data line, is formed at each pixel region (S101).

Then, a transparent metallic oxide such as Indium Tin Oxide (ITO) or Indium Zinc Oxide (IZO) is laminated on each pixel region and is etched, thereby forming an anode (S102). Then, an organic light emitting material is deposited on the entire display panels, thereby forming an organic light emitting layer (S103).

Then, a metal is laminated on the organic light emitting layer and is etched, thereby forming a cathode and forming an organic light emitting device (S104). Then, a sealant is laminated to complete an organic electroluminescent device.

Such an organic electroluminescent device may be fabricated by performing fabrication processes in a consecutive inline manner by a single roll to roll process line, or by performing some fabrication processes in a consecutive inline manner by a single roll to roll process line. Alternatively, such an organic electroluminescent device may be fabricated in a single inline manner, as a plurality of roll to roll process lines for performing respective processes are assembled to each other.

FIG. 2 is a flowchart showing a metal patterning process for forming an electrode of a display device such as an organic electroluminescent device, among the fabrication processes shown in FIG. 1.

As shown in FIG. 2, a metal is laminated on a film by a deposition method such as a sputtering, for metal patterning (S201). Then, a photoresist (PR) is applied onto the metal layer (S202).

Then, in a state that a part of the photoresist is blocked by arranging a photomask over the photoresist, light such as ultraviolet rays is irradiated (S203). Then, the photoresist is patterned by using a developing solution (S204). Then, in a state that a metallic layer is blocked by the patterned photoresist, the metallic layer is etched by using an etching solution, thereby forming an electrode (S205).

In the present disclosure, the metal patterning process is performed by the roll to roll fabrication apparatus. And all processes to laminate and etch a metal may be performed in a consecutive inline manner by a single roll to roll fabrication process. Alternatively or additionally, a process to laminate a metal, a process to apply a photoresist, an exposing process, a developing process, an etching process, etc., may be consecutively performed through roll to roll fabrication processes. Alternatively or additionally, two or more processes may be consecutively performed through a single roll to roll fabrication process.

In case of performing each process or a plurality of processes through roll to roll fabrication processes, a flexible film is supplied to the roll to roll fabrication apparatus to perform a corresponding process by consecutively transferring the film. Then, when the corresponding process is terminated, the film is transferred to another roll to roll fabrication apparatus to perform a corresponding process by consecutively transferring the film. In such a manner, the metal patterning process is completed.

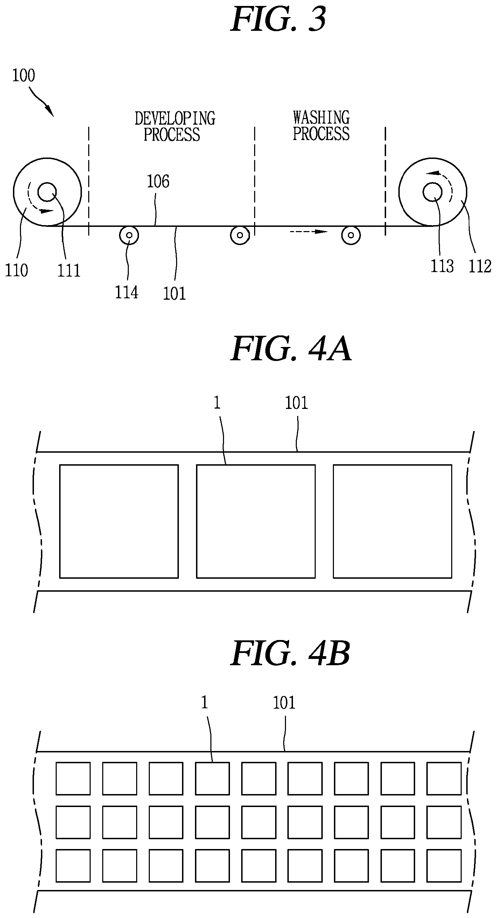

FIG. 3 is a schematic view showing the roll to roll fabrication apparatus 100 according to the present disclosure. As an non-limiting illustrative example, the roll to roll fabrication apparatus 100 shown in FIG. 3 serves to perform a developing process among the fabrication processes shown in FIG. 2. However, the roll to roll fabrication apparatus according to the present disclosure may be also used to perform another process such as an etching process.

As shown in FIG. 3, the roll to roll fabrication apparatus according to the present disclosure may include a first roll 110 (also referred to as a supplying roll) on which a film 101 formed of a ductile material such as plastic is wound, a second roll 112 (also referred to as a collecting roll) configured to collect the film 101 transferred from the first roll 110, and a plurality of guide rolls 114 disposed between the first roll 110 and the second roll 112 and configured to guide the transferred film 101. The first roll 110 and the second roll 112 are coupled to a first driving shaft 111 and a second driving shaft 113 connected to an external driving means. As the external driving means is driven, a driving force is transferred to the first and second rolls 110,112 through at least one of the first and second driving shafts 111, 113, thereby rotating the first and second rolls 110, 112.

As the first and second rolls 110, 112 are rotated, the film 101 is transferred toward the second roll 112 from the first roll 110. A developing unit for forming a photoresist pattern by developing a photoresist 106, and a washing unit for washing the developed photoresist pattern are provided on a transfer path of the film 101. Although not shown, a deposition unit for depositing a metal, a photoresist lamination unit for applying the photoresist 106 onto a laminated metallic layer, an exposing unit for exposing the photoresist 106 to light, and an etching unit for etching the metallic layer by using the developed photoresist pattern, may be further provided on the transfer path between the first roll 110 and the second roll 112. That is, the entire processes may be performed as metal patterning processes such as a metal laminating process, a photoresist applying process, an exposing process, a developing process and an etching process, are performed in a single consecutive inline manner, in the roll to roll fabrication apparatus shown in FIG. 3.

After the metal and the exposed photoresist 106 are formed on the film 101 by the previous roll to roll process, the film is transferred to another roll to roll fabrication apparatus shown in FIG. 3 by a transfer apparatus or an operator. After the roll to roll process shown in FIG. 3 is completed, the film 101 may be also transferred to a subsequent roll to roll fabrication apparatus by a transfer apparatus or an operator, and a corresponding process (an etching process) may be performed. That is, the steps of FIG. 2 are individually performed by separate roll to roll processes, and the film is transferred to a next process region after the steps are performed, thereby undergoing a roll to roll process.

FIGS. 4A and 4B are views showing the film 101 of the roll to roll fabrication apparatus according to the present disclosure.

As shown in FIG. 4A, a plurality of panel regions 1 are arranged in a line in a lengthwise direction of the film 101. The panel regions 1 are regions where various types of devices of a display device are formed. In case of an organic electroluminescent device, the panel regions 1 are organic electroluminescent display panels. And in case of an LCD device, the panel regions 1 are LC panels. All of the processes of FIG. 1 are performed on the panel regions 1 arranged on the film 101. After all of the processes are performed, the film 101 is cut so that the plurality of panel regions 1 are separated from one another in the form of unit display panels.

As shown in FIG. 4B, as the plurality of panel regions 1 are arranged in a plurality of lines in a lengthwise direction of the film 101, 'n x m' panel regions 1 may be formed on the film 101.

A developing process by the roll to roll fabrication apparatus of FIG. 3 is performed on the film 101 shown in FIGS. 4A and 4B. That is, a metallic layer is formed on each of the plurality of panel regions 1 formed on the film 101 by the previous process, and the photoresist 106 is laminated on the metallic layer. In this state, the film 101 is supplied to the roll to roll fabrication apparatus shown in FIG. 3, for a developing process.

Although not shown, the washing unit includes a first liquid washing portion for washing a developed photoresist pattern by using a cleaning solution, a bubble jet washing portion for washing the photoresist pattern by applying a bubble jet, a second liquid washing portion for washing the photoresist pattern by using a cleaning solution, an air knife for removing the cleaning solution which remains on the photoresist pattern by injecting air, and a heat washing portion for removing the cleaning solution which remains on the photoresist pattern by applying heat. Such washing processes are performed in real time and consecutively, while the film 101 is being transferred to the second roll 112 from the first roll 110.

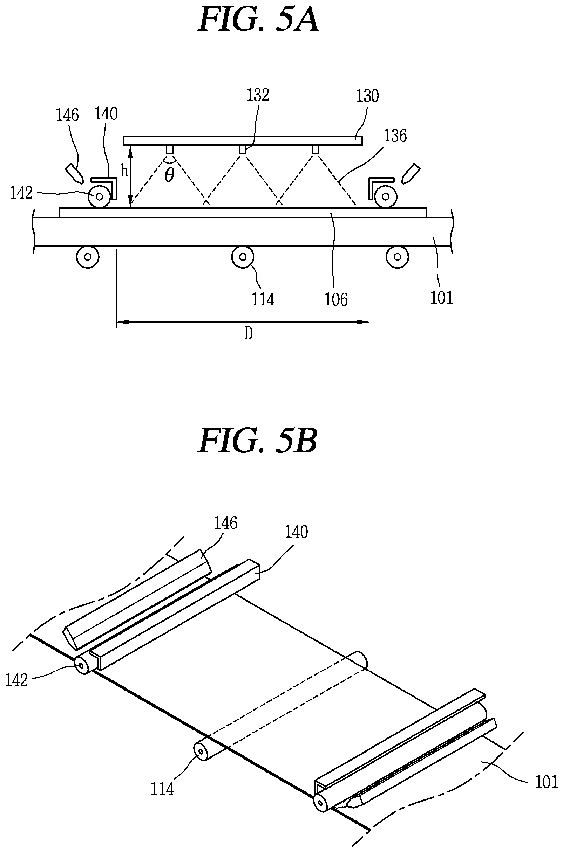

FIGS. 5A and 5B are views showing a structure of, e.g., a developing unit of the roll to roll fabrication apparatus according to the present disclosure. FIG. 5A is a sectional view of the roll to roll fabrication apparatus, and FIG. 5B is a perspective view of the roll to roll fabrication apparatus.

As shown in FIGS. 5A and 5B, the developing unit of the roll to roll fabrication apparatus according to the present disclosure includes a guide roll 114 for guiding the film 101 transferred to the second roll 112 from the first roll 110 shown in FIG. 3 and having the photoresist 106 on each of the plurality of panel regions; a developing solution inject plate 130 (also referred to as injection plate) disposed above the film 101, and configured to inject a developing solution 136 onto the photoresist 106 arranged on the film 101 which is to be transferred; a pair of air curtains 146 disposed at an inlet (a upstream end, a boundary region) and an outlet (an downstream end, a boundary region) of the developing unit, and configured to prevent the developing solution injected from the developing unit, e.g., developing solution inject plate 130, from being introduced to another process region (e.g., the washing unit) by injecting air; shielding members 140 disposed at the downstream and upstream ends (boundary regions) of the developing unit, configured to prevent the developing solution injected from the developing unit, e.g., developing solution inject plate 130, from splashing to another process region, and configured to prevent air injected from the air curtains 146 from being injected into the developing unit, and thereby to prevent the developing solution from being non-uniformly applied onto the film 101 disposed at the developing unit; and liquid blocking rolls 142 disposed at the downstream and upstream ends (boundary regions) of the developing unit, configured to prevent the developing solution applied onto the developing unit from being introduced to another process region, and configured to prevent air injected from the air curtains 146 from being directly injected onto the developing solution inside the developing unit.

A metallic layer is disposed on the film 101, and the photoresist 106 is applied onto the metallic layer. However, for convenience, the metallic layer is omitted in the drawings.

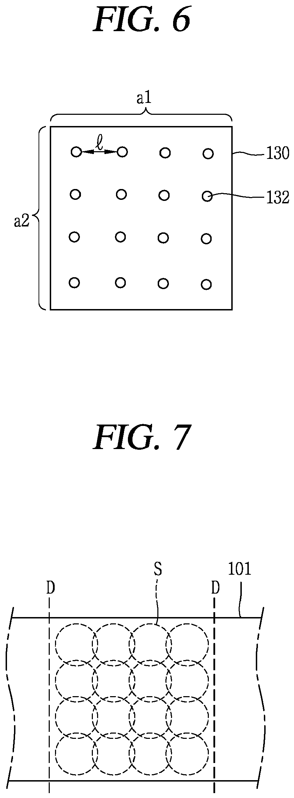

As shown in FIG. 6, the developing solution inject plate 130 is formed in an approximate quadrangular shape. Here, a horizontal length (a1) of the developing solution inject plate 130 is the same as a length (D) of a region where a developing process is substantially performed in the roll to roll fabrication apparatus, and a vertical length (a2) of the developing solution inject plate 130 is almost the same as a width of the film 101. Accordingly, when the developing solution inject plate 130 is arranged above the film 101, a developing region on the film 101 (one panel region or a plurality of panel regions) is covered by the developing solution inject plate 130. As a result, a developing solution is uniformly injected on an entire part of a corresponding panel region.

A plurality of nozzles 132 are provided at the developing solution inject plate 130. Although not shown, a cavity is formed in the developing solution inject plate 130 such that a developing solution is supplied into the cavity from an external developing solution supplying unit. And the developing solution supplied to the cavity is injected onto the film 101 through the nozzles 132.

The nozzles 132 are arranged at the developing solution inject plate 130 in a matrix shape with a preset interval (*ℓ*) therebetween. Here, a pitch between the nozzles 132 is determined based on a height (h) of the developing solution inject plate 130 disposed above the film 101, and based on an inject angle (θ) of the developing solution 136 injected from the nozzles 132. It is preferable to partially overlap inject regions on the film 101 with one another, where the developing solution from one nozzle 132 is injected.

That is, as shown in FIG. 7, the developing solution 136 injected from one nozzle 132 is applied onto circular inject regions (S) on the photoresist 106 of the film 101. And the inject regions (S) on which the developing solution 136 from the plurality of nozzles 132 are injected, are overlapped with neighboring inject regions (S). In this case, the nozzles 132 of the first row and the last row, provided at the developing solution inject plate 130, inject the developing solution 136 onto regions near boundary lines (D) for neighboring processes of the film 101. Preferably, edge regions of the inject regions (S) near the boundary lines (D) for neighboring processes overlap the boundary lines (D). The reason is because a large amount of developing solution may be introduced into another process region, as the large amount of developing solution is applied near the boundary lines (D) in a case where central regions of the inject regions (S) are positioned near the boundary lines (D).

Since the developing solution 136 has fluidity of a liquid state, it flows on the film 101 to thus be applied onto the film 101 with a uniform thickness, thereby uniformly developing the photoresist 106. As a result, the photoresist may be always patterned in a preset shape.

The roll to roll fabrication apparatus according to the present disclosure may be also applicable to another process such as an etching process, as well as a developing process. For instance, when the roll to roll fabrication apparatus according to the present disclosure is used for an etching process, an etching solution not a developing solution may be injected from the developing solution inject plate 130. In this case, the developing solution inject plate 130 may be referred to as an etching solution inject plate.

That is, the roll to roll fabrication apparatus according to the present disclosure may be applicable to all of fabrication processes of a display device. And the developing solution inject plate 130 includes a chemical treatment liquid such as chemicals used in a corresponding fabrication process.

The air curtains 146 are arranged at the upstream and downstream ends of the developing unit, i.e., near the two boundary lines (D), and serve to prevent the developing solution 136 injected onto the developing unit from being introduced to another process region, by injecting air onto the film 101 near the boundary lines (D).

Since the developing solution 136 has fluidity of a liquid state, it flows to another process region, even if it is applied onto the film 101 with a uniform thickness. Furthermore, the developing solution 136 injected to regions near the boundary lines (D) may be introduced to other regions by passing over the boundary lines (D) by an injection force of the nozzles 132. The air curtains 146 inject air onto the film 101 near the boundary lines (D), thereby preventing the developing solution from being introduced into other process regions.

The shielding members 140 prevent the developing solution injected from the developing unit from splashing to other process regions, and prevent a non-uniform application state of the developing solution disposed on the film 101 and arranged at the developing unit, by injecting air provided from the air curtains 146 into the developing unit. In the drawings, the shielding members 140 are formed in "┐"shape. However, the shielding members 140 may be formed in a vertical wall shape disposed vertically, or in another shape, which are all included in the disclosure. The shielding members 140 may be formed in any shape, if it can prevent air provided from the air curtains 146 from being injected to the developing unit, or if it can prevent the developing solution injected from the developing unit from splashing to other process regions.

The liquid blocking rolls 142 are arranged at the upstream and downstream ends of the developing unit, i.e., near the two boundary lines (D) of the developing unit. The liquid blocking rolls 142 are arranged between the two boundary lines (D) of the developing unit and the air curtains 146, and prevent air provided from the air curtains 146 from being directly injected onto the developing solution inside the developing unit. The reason is as follows.

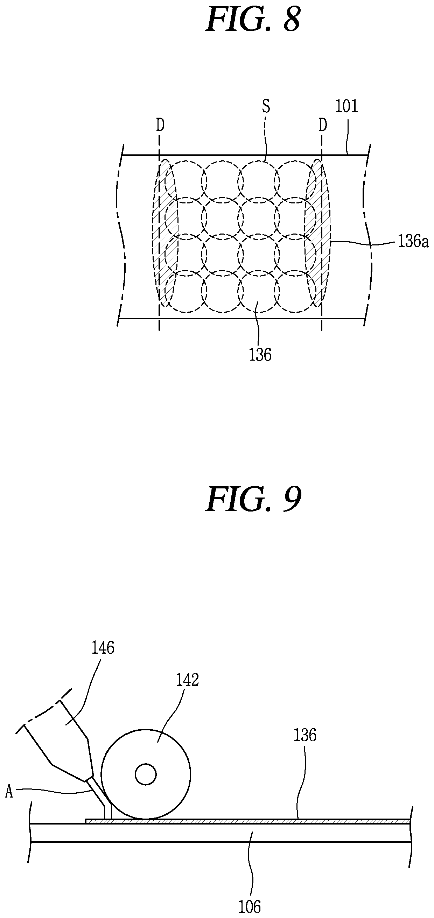

FIG. 8 is a view showing an injected state of the developing solution 136 onto the film 101, in a case where the liquid blocking rolls 142 are not provided. Since the developing solution 136 applied in a liquid state flows along the surface of the film 101 by its fluidity, it may flow to a next process region. The air curtains 146 are provided at the boundary lines (D) of the developing unit, thereby preventing the developing solution 136 from being introduced to other process regions by passing over the boundary lines (D).

However, in the case of preventing the flow of the developing solution by injecting air, the developing solution backflows to the developing unit by an injection force of the air. As a result, the developing solution is not uniformly applied to the developing unit. Accordingly, as shown in FIG. 8, as force of air is applied to the developing solution 136 near the boundary lines (D), foam 136a is generated from the developing solution.

The developing solution 136 applied onto the photoresist 106 is chemically bonded with the photoresist 106, thereby removing the photoresist 106 in a developing manner. However, such foam 136a prevents a contact between the developing solution 136 and the photoresist 106, thereby lowering a bonding therebetween. Accordingly, the photoresist 106 is incompletely developed by the foam 136a, and the undesired photoresist 106 remains on a metallic layer. Eventually, the metallic layer cannot be completely etched, resulting in inferior display panels.

The liquid blocking rolls 142 of the preset disclosure prevent air provided from the air curtains 146 from being directly applied onto the developing solution 136 applied onto the photoresist 106, thereby preventing a backflow of the developing solution 136 and occurrence of foam.

As shown in FIG. 9, in the present disclosure, air (A) provided from the air curtain 146 is not directly injected onto the developing solution applied onto the photoresist 106 on the film 101, but is injected onto the liquid blocking roll 142. Accordingly, the air (A) provided from the air curtain 146 is injected to a lower part of an outer side of the liquid blocking roll 142 (i.e., an outer side of the developing unit), via an outer circumferential surface of the liquid blocking roll 142.

Since the air (A) is not directly injected into the developing unit, it is not directly applied onto the developing solution 136 inside the developing unit, or the developing solution 136 being injected. This prevents the developing solution 136 from flowing to another process region. Further, this prevents splashing of the developing solution 136 to a neighboring process region, or a non-uniform application of the developing solution inside the developing unit, through air injection.

Since the air (A) provided from the air curtain 146 is injected via the outer circumferential surface of the liquid blocking roll 142, a force to block the developing solution 136 is reduced. However, since the developing solution 136 is primarily prevented from flowing to another process region by the liquid blocking roll 142, the overall blocking efficiency for the developing solution 136 is not lowered.

Further, in the present disclosure, since the air (A) is not directly injected onto the developing solution 136, occurrence of foam 136a due to the air injection is prevented. Also, even when foam occurs, the foam is prevented from being introduced into the developing unit by the liquid blocking roll 142. This prevents a non-uniform state of the photoresist due to foam occurring in the developing solution 136.

Moreover, in the present disclosure, since the liquid blocking roll 142 is spaced apart from the film 101 by a preset distance, the developing solution 136 applied onto the film 101, when the film 101 is transferred while passing through the liquid blocking roll 142, has its thickness maintained constantly as a thickness between the liquid blocking roll 142 and the photoresist. Accordingly, the photoresist may be developed more uniformly.

Further, since the liquid blocking roll 142 is installed to be moveable up and down, an interval between the liquid blocking roll 142 and the film 101 can be controlled. As the interval between the liquid blocking roll 142 and the film 101 is controlled according to a thickness of the photoresist and a type of the developing solution, etc., a developing operation may be efficiently performed.

In the present disclosure, the developing solution is primarily prevented from being introduced to another process region from the developing unit, by the liquid blocking rolls 142. And the developing solution is secondarily prevented from being introduced to another process region, through air injection by the air curtains 146. This effectively prevents the developing solution from being introduced to another process region.

Moreover, in the present disclosure, air injected from the air curtains 146 is not directly applied into the developing unit by the liquid blocking rolls 146. Accordingly, occurrence of foam from a developing solution inside the developing unit is prevented, and the developing solution maintains a constant thickness by the liquid blocking rolls 146. This allows a photoresist pattern to maintain a constant thickness.

When the liquid blocking rolls 146 are not provided, a maximum deviation of a photoresist pattern to be developed is more than about 1.8µm. On the other hand, when the roll to roll fabrication apparatus of the present disclosure is used, the deviation of the photoresist pattern is reduced to about 0.54µm. Accordingly, in case of etching a metallic layer, etc., an inferiority due to the deviation of the photoresist pattern is reduced. Further, even when a small amount of photoresist is applied, a desired etching operation is performed without an inferiority. This reduces the fabrication costs, and prevent environmental pollution due to a large amount of photoresist.

## Claims

1. A roll to roll fabrication apparatus for the fabrication of devices including a metallic layer patterning process (100), comprising:
a supplying roll (110) and a collecting roll (112) configured to transfer a film (101) therebetween;
an injection plate (130) above a transfer path of the film (101), which is configured to inject a chemical treatment liquid (136) on the film (101) in a corresponding process region;
liquid blocking rolls (142), blocking the flow of chemical treatment liquid (136), at downstream and upstream boundaries of the corresponding process region; and
air curtains (146) at the downstream and upstream boundaries of the corresponding process region, wherein the air curtains (146) are arranged such that the air (A) provided from the air curtains (146) is injected onto the liquid blocking rolls (142) and wherein the liquid blocking rolls (142) are arranged between the air curtains (146) and the corresponding process region such that they prevent the air (A) provided from the air curtains (146) from being directly injected onto the chemical treatment liquid (136) inside the corresponding process region.

2. The roll to roll fabrication apparatus (100) of claim 1, configured to apply the injection plate (130) as a developing solution injection plate for injecting a developing solution as the chemical treatment liquid (136).

3. The roll to roll fabrication apparatus (100) of claim 1, configured to apply the injection plate (130) as an etching solution injection plate for injecting an etching solution as the chemical treatment liquid (136).

4. The roll to roll fabrication apparatus (100) of any one of claims 1 to 3, further comprising shielding members (140) at the downstream and upstream boundaries of the corresponding process region, wherein the shielding members (140) are configured to prevent the chemical treatment liquid (136) injected from the injection plate (130) from splashing to another process region and to prevent air injected from the air curtains (146) from being injected into the process region.

5. The roll to roll fabrication apparatus (100) of any one of claims 1 to 4, wherein the liquid blocking rolls (142) are moveable up and down.

6. The roll to roll fabrication apparatus (100) of claim 5, wherein the liquid blocking rolls (142) are configured to perform an up-down movement so as to control an interval between the liquid blocking rolls (142) and the film (101) based at least in part on a thickness of a chemical treatment liquid (136) to be applied.

7. The roll to roll fabrication apparatus (100) of claim 1, wherein the liquid blocking rolls (142) are spaced apart from the film (101) by a preset distance.

## Patentansprüche

1. Rolle-zu-Rolle-Herstellungsvorrichtung zum Herstellen von Vorrichtungen aufweisend einen Metallschicht-Strukturierungsvorgang (100), aufweisend:
eine Zuführrolle (110) und eine Sammelrolle (112), die konfiguriert sind, um einen Film (101) dazwischen zu übertragen,
eine Injektionsplatte (130) über einem Übertragungspfad des Films (101), die konfiguriert ist, um eine chemische Behandlungsflüssigkeit (136) in einem jeweiligen Prozessbereich auf den Film (101) zu injizieren,
Flüssigkeitsblockierrollen (142), die den Strom der chemischen Behandlungsflüssigkeit (136) an Stromabwärts- und Stromaufwärts-Grenzen des jeweiligen Prozessbereichs blockieren, und
Luftschleier (146) an den Stromabwärts- und Stromaufwärts-Grenzen des jeweiligen Prozessbereichs,
wobei die Luftschleier (146) derart angeordnet sind, dass die von den Luftschleiern (146) bereitgestellte Luft (A) auf die Flüssigkeitsblockierrollen (142) injiziert wird, und wobei die Flüssigkeitsblockierrollen (142) zwischen den Luftschleiern (146) und dem jeweiligen Prozessbereich angeordnet sind, so dass sie verhindern, dass die von den Luftschleiern (146) bereitgestellte Luft (A) direkt auf die chemische Behandlungsflüssigkeit (136) innerhalb des jeweiligen Prozessbereichs injiziert wird.

2. Rolle-zu-Rolle-Herstellungsvorrichtung (100) gemäß Anspruch 1, die konfiguriert ist, um die Injektionsplatte (130) als Entwicklerlösung-Injektionsplatte zum Injizieren einer Entwicklerlösung als chemische Behandlungsflüssigkeit (136) anzuwenden.

3. Rolle-zu-Rolle-Herstellungsvorrichtung (100) gemäß Anspruch 1, die konfiguriert ist, um die Injektionsplatte (130) als eine Ätzlösungs-Injektionsplatte zum Injizieren einer Ätzlösung als chemische Behandlungsflüssigkeit (136) anzuwenden.

4. Rolle-zu-Rolle-Herstellungsvorrichtung (100) gemäß irgendeinem der Ansprüche 1 bis 3, ferner aufweisend Abschirmelemente (140) an den Stromabwärts- und Stromaufwärts-Grenzen des jeweiligen Prozessbereichs, wobei die Abschirmelemente (140) konfiguriert sind, um zu verhindern, dass die chemische Behandlungsflüssigkeit (136), die von der Injektionsplatte (130) injiziert wird, auf einen anderen Prozessbereich gespritzt wird, und um zu verhindern, dass aus den Luftschleiern (146) injizierte Luft in den Prozessbereich injiziert wird.

5. Rolle-zu-Rolle-Herstellungsvorrichtung (100) gemäß irgendeinem der Ansprüche 1 bis 4, wobei die Flüssigkeitsblockierrollen (142) nach aufwärts und abwärts bewegbar sind.

6. Rolle-zu-Rolle-Herstellungsvorrichtung (100) gemäß Anspruch 5, wobei die Flüssigkeitsblockierrollen (142) konfiguriert sind, um eine Aufwärts-Abwärtsbewegung durchzuführen, um ein Intervall zwischen den Flüssigkeitsblockierrollen (142) und dem Film (101) zumindest teilweise auf der Grundlage einer Dicke einer aufzubringenden chemischen Behandlungsflüssigkeit (136) zu steuern.

7. Rolle-zu-Rolle-Herstellungsvorrichtung (100) gemäß Anspruch 1, wobei die Flüssigkeitsblockierrollen (142) in einem vorgegebenen Abstand von dem Film (101) angeordnet sind.

## Revendications

1. Appareil de fabrication rouleau à rouleau pour la fabrication de dispositifs comprenant un procédé de structuration de couches métalliques (100), comprenant :
un rouleau d'alimentation (110) et un rouleau de collection (112) configurés pour transférer un film (101) entre eux ;
une plaque d'injection (130) au-dessus d'un chemin de transfert du film (101), qui est configurée pour injecter un liquide de traitement chimique (136) sur le film (101) dans une région de traitement correspondante ;
des rouleaux de blocage de liquide (142), bloquant l'écoulement de liquide de traitement chimique (136) à des limites aval et amont de la région de traitement correspondante ; et
des rideaux d'air (146) aux limites aval et amont de la région de traitement correspondante ;
dans lequel les rideaux d'air (146) sont disposés de telle sorte que l'air (A) fourni par les rideaux d'air (146) est injecté sur les rouleaux de blocage de liquide (142), et dans lequel les rouleaux de blocage de liquide (142) sont disposés entre les rideaux d'air (146) et la région de traitement correspondante de telle sorte qu'ils empêchent l'air (A) fourni par les rideaux d'air (146) d'être directement injecté sur le liquide de traitement chimique (136) à l'intérieur de la région de traitement correspondante.

2. Appareil de fabrication rouleau à rouleau (100) selon la revendication 1, configuré pour appliquer la plaque d'injection (130) en tant que plaque d'injection de solution de développement pour injecter une solution de développement en tant que solution de liquide de traitement chimique (136).

3. Appareil de fabrication rouleau à rouleau (100) selon la revendication 1, configuré pour appliquer la plaque d'injection (130) en tant que plaque d'injection de solution de gravure pour injecter une solution de gravure en tant que solution de liquide de traitement chimique (136).

4. Appareil de fabrication rouleau à rouleau (100) selon l'une quelconque des revendications 1 à 3, comprenant en outre des éléments de protection (140) aux limites aval et amont de la région de traitement correspondante, dans lequel les éléments de protection (140) sont configurés pour empêcher le liquide de traitement chimique (136) injecté à partir de la plaque d'injection (130) d'éclabousser vers une autre région de traitement et pour empêcher l'injection d'air injecté à partir des rideaux d'air (146) dans la région de traitement.

5. Appareil de fabrication rouleau à rouleau (100) selon l'une quelconque des revendications 1 à 4, dans lequel les rouleaux de blocage de liquide (142) sont mobiles de haut en bas.

6. Appareil de fabrication rouleau à rouleau (100) selon la revendication 5, dans lequel les rouleaux de blocage de liquide (142) sont configurés pour effectuer un mouvement de haut en bas de manière à contrôler un intervalle entre les rouleaux de blocage de liquide (142) et le film (101) sur la base au moins en partie d'une épaisseur d'un liquide de traitement chimique (136) à appliquer.

7. Appareil de fabrication rouleau à rouleau (100) selon la revendication 1, dans lequel les rouleaux de blocage de liquide (142) sont espacés du film (101) d'une distance préréglée.
